# EUROPÄISCHE PATENTANMELDUNG

(11) **EP 4 823 262 A1**
(43) Veröffentlichungstag der Anmeldung: **14.10.2026**
(21) Anmeldenummer: 26168825.3
(22) Anmeldetag: 30.03.2026
(51) Int. Cl.: H05K 7/20, B60L 53/302, H01B 7/42, H01R 13/00, H01R 13/74

(54) **ELEKTRISCHE ANSCHLUSSEINRICHTUNG MIT EINER KÜHLBAREN ELEKTRISCHEN LEITUNG**

(30) Priorität: 01.04.2025 DE 102025112702
(71) Anmelder: LEONI Bordnetz-Systeme GmbH, 97318 Kitzingen (DE); LEONI Wiring Systems Slovakia spol. s r.o., 911 01 Trencin (SK)
(72) Erfinder: ENGBRING, Jürgen, 97346 Iphofen (DE); GÖPPNER, Fabian, 97320 Großlangheim (DE); PEREZ LAZCANO, Fernando, 97204 Höchberg (DE); SMOLAN, Peter, 91101 Trencin (SK)
(74) Vertreter: FDST Patentanwälte

(57) **Zusammenfassung**

Die Elektrische Anschlusseinrichtung (2) dient zum Anschluss einer kühlbaren und insbesondere geschirmten elektrischen Leitung (4, 4A) an eine elektrischen Komponente (24), insbesondere zum Anschluss einer elektrischen Hochleistungsleitung in einem Kraftfahrzeug, und weist die elektrische Leitung (4, 4A) sowie ein Anschlussterminal (6) auf, wobei die elektrische Leitung (4, 4A) einen zentralen Fluidschlauch (8, 8A, 8B) für ein Kühlmittel aufweist, und mit einem Endabschnitt in das Anschlussterminal (6) eingeführt ist. Das Anschlussterminal (6) weist einen ersten Fluidstutzen (8, 8A) sowie einen zweiten Fluidstutzen (8, 8B) auf, die über einen Fluidkanal (30) miteinander verbunden sind, wobei an dem ersten Fluidstutzen (8, 8A) der Fluidschlauch (8, 8A, 8B) angeschlossen ist und an dem zweiten Fluidstutzen (8, 8B) ein weiterer Fluidschlauch (8, 8A, 8B) zur Ausbildung eines Fluidkreislaufes zumindest anschließbar ist. Hierdurch ist eine hybride Schnittstelle einer insbesondere geschirmten Leitung (4, 4A) bei zuverlässiger Kühlung erreicht.

## Beschreibung

Die Erfindung betrifft eine elektrische Anschlusseinrichtung insbesondere eines Kraftfahrzeuges mit einer kühlbaren elektrischen Leitung und mit einem Anschlussterminal, über die die elektrische Leitung im montierten Zustand an einer elektrischen Komponente angeschlossen ist. Insbesondere handelt es sich um eine Anschlusseinrichtung für eine elektrische Hochleistungsleitung in einem Kraftfahrzeug. Die Anschlusseinrichtung weist die kühlbare Leitung sowie ein als eine hybride Anschlussschnittstelle ausgebildetes Anschlussterminal auf. Die kühlbare elektrische Leitung weist eine Fluidleitung für ein Kühlmittel und einen elektrischen Leiter zur Stromübertragung auf. Die elektrische Leitung ist mit einem Endabschnitt in das Anschlussterminal eingeführt.

Aufgrund steigender Leistungsanforderungen für die elektrische Leistungsübertragung speziell bei Elektrofahrzeugen ist eine geeignete Auslegung der elektrischen Systeme erforderlich. Sofern vorliegend von Hochleistungsleitungen gesprochen wird, so wird hierunter verstanden, dass die Leitung und damit auch die Anschlusseinrichtung zur Übertragung von zumindest 100 kW und bei neueren Entwicklungen bis in den Megawatt-Bereich ausgelegt sind. Bei derartigen Systemen und unter den typischen Bauraum-Beschränkungen im Kraftfahrzeug werden zunehmend aktiv gekühlte elektrische Systeme eingesetzt, um die thermische Belastung gering zu halten.

Hierzu werden kühlbare elektrische Leitungen verwendet. Diese können unterschiedlich ausgebildet sein und weisen allgemein eine integrierte Fluidleitung auf.

Eine Herausforderung bei derartigen aktiv gekühlten Systemen ist jeweils die mechanische und elektrische Schnittstelle der Leitung zu der elektrischen Komponente über ein geeignet ausgebildetes Anschlussterminal. Aus Sicherheitsaspekten muss eine Dichtheit des Kühlsystems gewährleistet sein. Eine Einführung der Fluidleitung in die elektrische Komponente ist in der Regel nicht erwünscht.

Ausgehend hiervon liegt der Erfindung die Aufgabe zugrunde, eine elektrische Anschlusseinrichtung mit einer kühlbaren elektrische Leitung, insbesondere eine Hochleistungsleitung eines Kraftfahrzeugs anzugeben, die im montierten Zustand an einer elektrischen Komponente angeschlossen ist, wobei eine zuverlässige Kühlung gewährleistet ist.

Die Aufgabe wird gemäß der Erfindung gelöst durch eine Anschlusseinrichtung mit den Merkmalen des Anspruchs 1. Diese weist eine kühlbare elektrische Leitung, insbesondere eine elektrischen Hochleistungsleitung auf, die zur Übertragung von zumindest mehreren 100 kW ausgebildet ist und die im montierten Zustand in einem Kraftfahrzeug verbaut ist. Die Anschlusseinrichtung weist die elektrische Leitung sowie ein Anschlussterminal auf, welches als eine hybride Anschlussschnittstelle zum elektrischen Anschluss mit integrierter Kühlung ausgebildet ist. Die elektrische Leitung weist eine integrierte Fluidleitung für ein Kühlmittel, insbesondere ein Glykol-Wasser-Gemisch, einen Leiter zur Stromübertragung und einen isolierenden Leitungsmantel auf, welcher insbesondere als ein extrudierter Mantel ausgebildet ist. Die elektrische Leitung weist weiterhin einen Endabschnitt auf, mit dem sie in das Anschlussterminal eingeführt ist und zwar üblicherweise gegenüber der Umgebung abgedichtet (wasserdicht, insbesondere längswasserdicht, staubdicht usw.). Das Anschlussterminal weist ein Terminalgehäuse, welches im montierten Zustand mit einer Basis verbunden ist. Das Anschlussterminal weist eine erste sowie eine zweite hydraulische Schnittstelle auf, die über einen in der Basis integrierten Fluidkanal miteinander verbunden sind, wobei an der ersten hydraulischen Schnittstelle die Fluidleitung der elektrischen Leitung angeschlossen ist und an der zweiten hydraulischen Schnittstelle eine weitere Fluidleitung zur Ausbildung eines Fluidkreislaufes zumindest anschließbar ist oder angeschlossen ist.

Innerhalb des Anschlussterminals ist der Leiter typischerweise an einen durch die Basis hindurchgeführten Anschlussleiter angeschlossen. Dies erfolgt insbesondere durch einen Kontaktverbinder, welcher einerseits den Leiter insbesondere klemmend kontaktiert und andererseits mit dem Anschlussleiter verbunden ist. Der Anschlussleiter ist beispielsweise als ein massiver Leiterstab oder als eine massive Stromschiene ausgebildet. Über den Anschlussleiter wird im Betrieb die elektrische Leistung in die angeschlossene Komponente übertragen.

Zur Ausbildung des Fluidkanals als ein integraler Bestandteil der Basis ist an der Basis insbesondere ein Kanalabschnitt ausgebildet, beispielsweise durch eine Nut oder durch eine Materialausnehmung innerhalb der Basis oder durch eine geeignete Formkontur der Basis. Der Kanalabschnitt ist insbesondere einseitig offen und mit einem Deckel dicht verschließbar. Über die hydraulischen Schnittstellen ist eine Strömungsverbindung in diesen Kanalabschnitt ausgebildet. Bei der Basis handelt es sich insbesondere um ein monolithisches Bauteil, beispielsweise um ein Gussbauteil, sodass die integrale Ausbildung des Kanalabschnitts als Teil der Basis fertigungstechnisch einfach umsetzbar ist.

Von besonderer Bedeutung bei dem hier beschriebenen Anschlussterminal ist dessen Ausgestaltung mit den beiden hydraulischen Schnittstellen, die über einen in der Basis integrierten Fluidkanal miteinander verbunden sind. Im Betrieb wird hierdurch die Möglichkeit geschaffen, ein geeignetes Kühlsystem mit einem Kühlkreislauf bereitzustellen, über den zuverlässig die elektrische Leitung und insbesondere auch das Anschlussterminal und / oder die Basis gekühlt wird, bei dem gleichzeitig jedoch vermieden ist, dass die Fluidleitung in die Komponente eingeführt wird. Maßgebend hierfür sind die beiden über den Fluidkanal miteinander verbundenen hydraulischen Schnittstellen, so dass das Kühlmittel über die Basis in den Fluidschlauch hinein oder aus diesem herausgeführt werden kann. Die erste hydraulische Schnittstelle ist bevorzugt innerhalb des Terminalgehäuses angeordnet. Die zweite hydraulische Schnittstelle ist bevorzugt außerhalb des Terminalgehäuses der angeschlossenen elektrischen Leitung angeordnet.

Bei der Fluidleitung handelt es sich beispielsweise um ein separates Element, welches innerhalb eine Leitungsaufbaus der elektrischen Leitung integriert ist. Beispielsweise ist sie als ein (biegeflexibler) Fluidschlauch oder als ein Rohr ausgebildet. Alternativ ist die Fluidleitung beispielsweise ein in einem Träger integrierter Fluidkanal. In einer weiteren Ausführungsvariante ist die Fluidleitung durch einen insbesondere durch ein Metallrohr gebildeten elektrischen Hohlleiter gebildet, bei dem durch das Metallrohr der elektrische Leiter und durch den inneren Hohlraum zugleich auch die Fluidleitung ausgebildet ist. Innerhalb des Hohlraums kann auch ein Fluidschlauch geführt sein.

Die elektrische Leitung weist insbesondere genau einen elektrischen Leiter auf. Alternativ hierzu umfasst die elektrische Leitung auch mehrere elektrische Leiterstränge, die z.B. von einem gemeinsamen Leitungsmantel umgeben sind.

In einer bevorzugter Ausgestaltung ist die Fluidleitung durch einen zentralen innerhalb des elektrischen Leiters geführten Fluidschlauch ausgebildet. Der elektrische Leiter ist hierbei insbesondere durch eine den Fluidschlauch insbesondere unmittelbar umgebende Leiterlage gebildet, die beispielsweise als Rohr, bevorzugt jedoch als eine biegeflexible Lage, z.B. durch ein Geflecht, insbesondere durch einen Geflechtschlauch ausgebildet ist.

Die hydraulischen Schnittstellen sind allgemein als mechanische Schnittstellen zum Anschluss der Fluidleitung an den Fluidkanal der Basis ausgebildet. Sie weisen hierzu insbesondere jeweils einen Fluidstutzen auf oder sind durch diesen gebildet, an dem die Fluidleitung angeschlossen ist. Der Fluidstutzen ist entweder unmittelbarer Bestandteil der Basis oder zumindest im montierten Zustand in eine Stutzenaufnahme der Basis eingesteckt, die mit dem Kühlkanal verbunden ist. Beispielsweise wird zunächst die Fluidleitung an den Fluidstutzen angeschlossen und erst anschließend wird dieser in die Stutzenaufnahme der Basis eingesteckt.

Die Basis ist vorzugsweise plattenförmig ausgebildet oder weist zumindest ein plattenförmiges Element auf. Sie bildet im montierten Zustand insbesondere einen Boden für das Terminalgehäuse aus. Die Basis verschließt das Terminalgehäuse bodenseitig. Der zuvor beschriebene elektrische Anschlussleiter, welcher in die angeschlossene Komponente hineingeführt wird, wird bevorzugt durch diese Basis hindurchgeführt und zwar insbesondere abgedichtet (speziell längswasserdicht). Die Basis ist vorzugsweise ein massives, insbesondere monolithisches Bauteil aus Kunststoff, vorzugsweise jedoch aus Metall und insbesondere Aluminium.. Das Terminalgehäuse ist an der Basis vorzugsweise reversibel befestigbar, beispielsweise über Schrauben oder über eine Schnappverbindung.

Die Basis ist insbesondere Teil einer Gehäusewand eines Komponentengehäuses der Komponente. Beispielsweise bildet die Basis selbst einen Deckel, einen Boden oder einen Wandabschnitt des Komponentengehäuses und verschließt dieses. Durch den integrierten Fluidkanal wird daher zugleich eine Kühlung der Komponente erreicht.

Alternativ wird die Basis lediglich auf einen Wandabschnitt des Komponentengehäuses angebracht, insbesondere angeschraubt oder angeschweißt.

Die beiden hydraulischen Schnittstellen, insbesondere Fluidstutzen sind insbesondere an der zum Terminalgehäuse zugewandten Seite der Basis und damit an der zur angeschlossenen Komponente abgewandten Seite der Basis angeordnet. Dadurch ist vermieden, dass Fluidleitungen, speziell Fluidschläuche innerhalb der angeschlossenen Komponente verlaufen.

Bevorzugt ist die Basis aus Metall, und zwar bevorzugt aus Aluminium ausgebildet, und zwar insbesondere nach Art einer Kühlplatte. In Verbindung mit dem integrierten Fluidkanal wird hierdurch eine aktive Kühlung der gesamten Basis erreicht, sodass durch die gekühlte Basis der gesamte Anschlussbereich aktiv gekühlt wird. Durch diese Maßnahme wird daher insbesondere auch die elektrische Kontaktverbindung zwischen dem Leiter und dem Anschlussleiter zumindest mittelbar gekühlt. Da das Anschlussterminal über die Basis mit der angeschlossenen Komponente zumindest verbunden ist oder die Basis bevorzugt Teil des Komponentengehäuses der Komponente ist, wird darüber hinaus zugleich auch eine aktive Kühlung der angeschlossenen Komponente ermöglicht.

In zweckdienlicher Weise ist der in der Basis ausgebildete Kühlkanal Teil einer insbesondere flächenhaften Kühlstruktur, die mehrere miteinander verbundene und über die Fläche der Basis und/oder über das Komponentengehäuse, insbesondere über mindestens einen Wandabschnitt des Komponentengehäuses verteilte und unterschiedlich orientierte Kanalabschnitte aufweist. Diese verlaufen beispielsweise mäanderförmig.

Gemäß einer Ausführungsvariante erstreckt sich der Fluidkanal jedoch insbesondere gradlinig und auf direktem Weg zwischen die beiden hydraulischen Schnittstellen, die im montierten Zustand insbesondere an einer gemeinsamen Anschlussseite der Komponente und damit der typischerweise plattenförmigen Basis ausgebildet sind. Die beiden hydraulischen Schnittstellen sind allgemein beispielsweise nebeneinander an der einer solchen gemeinsamen Anschlussseite der Basis ausgebildet und z.B. nur wenige Zentimeter (3 cm bis maximal 10 cm) voneinander beabstandet.

In bevorzugter Ausgestaltung ist der Fluidschlauch als ein zentraler Fluidschlauch ausgebildet, welcher innerhalb des Leiters geführt ist.

Bevorzugt tritt der Fluidschlauch endseitig, also in Längsrichtung der elektrischen Leitung, aus dem Leiter heraus. Dies hat bei einer derartigen Anordnung der Fluidleitung als zentrales Element innerhalb des Leiters den Vorteil, dass ein seitlicher Anschluss der Fluidleitung oder ein seitliches Herausführen der Fluidleitung durch die restlichen Komponenten der Leitung hindurch, nicht erforderlich ist.

In bevorzugter Ausgestaltung ist eine weitere (zweite) elektrische Leitung mit einer Fluidleitung vorgesehen, welche ebenfalls über eine hydraulische Schnittstelle an der Basis angeschlossen ist. Die weitere elektrische Leitung ist insbesondere identisch zu der zuvor beschriebenen (ersten) elektrischen Leitung und damit als kühlbare elektrische Leitung ausgebildet. Durch die beiden gemeinsam an der Basis angeschlossenen Fluidleitungen kann der gewünschte Kühlkreislauf ausgebildet werden, sodass der eine Fluidschlauch im Betrieb einen Rücklauf und der andere Fluidschlauch einen Vorlauf bildet.

Die (erste) elektrische Leitung - und vorzugsweise auch die weitere elektrische Leitung - ist (sind) vorzugsweise als eine einadrige und/oder mehradrige Mantelleitung, beispielsweise als eine flexible Litzenleitung ausgebildet. Die Leitung ist insbesondere eine Gleichstromleitung, die im angeschlossenen Zustand auf einem positiven (bzw. negativen) Betriebspotenzial einer Gleichstromversorgung angeschlossen ist. Bei der bevorzugten Ausgestaltung mit den zwei elektrischen Leitungen ist die Anschlusseinrichtung daher als eine gemeinsame Anschlusseinrichtung für Hin- und Rückleiter einer Gleichstromversorgung ausgebildet.

Die Basis bildet eine gemeinsame Basis für die beiden elektrischen Leitungen aus, an der die beiden Fluidleitungen angeschlossen sind. Durch die Basis ist für jede Leitung ein Anschlussleiter hindurchgeführt und im montierten Zustand in die Komponenten hineingeführt.

Gemäß einer bevorzugten ersten Ausführungsvariante ist der Fluidkanal der Basis als ein Verbindungskanal ausgebildet und die Fluidleitung der weiteren elektrischen Leitung ist an der zweiten hydraulischen Schnittstelle angeschlossen. Dies bedeutet, dass die beiden angeschlossenen Fluidleitungen der beiden Leitungen über den durch die Basis bereitgestellten Fluidkanal miteinander verbunden sind. Eine jeweilige hydraulische Schnittstelle, insbesondere Fluidstutzen, ist insbesondere innerhalb eines jeweiligen Terminalgehäuses der beiden elektrischen Leitungen angeordnet. Die Fluidleitung der weiteren elektrischen Leitung bildet in diesem Fall die weitere Fluidleitung, welche an der zweiten hydraulischen Schnittstelle angeschlossen ist. Die zweite hydraulische Schnittstelle ist hierzu an einer gemeinsamen (Anschluss-) Seite der Basis neben der ersten hydraulische Schnittstelle angeordnet. Der Fluidkanal erstreckt sich hierzu insbesondere geradlinig und ist nur wenige Zentimeter lang, wie dies zuvor erläutert wurde.

Alternativ zu der Ausführungsvariante als Verbindungskanal ist der Fluidkanal als ein Versorgungskanal zur Verbindung mit einer Kühlmittelversorgung ausgebildet.

Die zweite hydraulische Schnittstelle ist hierbei als eine Anschlussschnittstelle zum Anschluss an eine Kühlmittel-Versorgungsleitung ausgebildet. Diese Kühlmittel-Versorgungsleitung bildet in diesem Fall die weitere Fluidleitung. Auch bei dieser Variante ist Die zweite hydraulische Schnittstelle an einer gemeinsamen (Anschluss-) Seite der Basis neben der ersten hydraulische Schnittstelle angeordnet. Der Fluidkanal erstreckt sich insbesondere geradlinig und ist nur wenige Zentimeter lang, wie dies zuvor erläutert wurde.

Die zweite hydraulische Schnittstelle ist bei dieser Variante insbesondere frei von außen zugänglich, d. h. insbesondere außerhalb des Terminalgehäuses angeordnet. An dieser insbesondere als Anschlussstutzen ausgebildeten Anschlussschnittstelle kann die Kühlmittel-Versorgungsleitung angeschlossen werden und ist im endmontierten Zustand angeschlossen. Diese Versorgungsleitung ist beispielsweise im montierten Zustand mit einer Kühlmittelpumpe strömungstechnisch verbunden und insbesondere an dieser angeschlossen. Diese Kühlmittel-Versorgungsleitung bildet allgemein die weitere Fluidleitung aus, welche also am Anschlussstutzen (Anschlussschnittstelle) angeschlossen ist. Über die Anschlussleitung wird im Betrieb das Kühlmittel in das Anschlussterminal eingespeist (Vorlauf) bzw. wieder herausgeführt (Rücklauf).

Bei der Variante mit den beiden elektrischen Leitungen sind in bevorzugter Ausgestaltung die beiden Fluidleitungen dieser beiden elektrischen Leitungen jeweils an einer ersten hydraulischen Schnittstelle angeschlossen und jede dieser ersten hydraulischen Schnittstellen ist jeweils mit einer Anschlussschnittstelle über jeweils einen Fluidkanal verbunden. Bei der Ausführungsvariante des Fluidkanals als Versorgungskanal sind daher insbesondere genau zwei Fluidkanäle ausgebildet, die jeweils eine erste hydraulische Schnittstelle mit einer Anschlussschnittstelle verbinden. Bevorzugt sind beide Fluidkanäle integraler Bestandteil der gemeinsamen Basis.

In bevorzugter Ausbildung ist an der elektrischen Leitung an gegenüberliegenden Enden jeweils ein Anschlussterminal angeschlossen und die Fluidleitung ist an zwei Basen jeweils über eine hydraulische Schnittstelle angeschlossen. Über die elektrische Leitung sind im montierten Zustand zwei elektrische Komponenten miteinander verbunden. Über das eine Anschlussterminal erfolgt daher der Anschluss an die eine Komponente und über das weitere Anschlussterminal erfolgt der Anschluss an der weiteren Komponente.

Bevorzugt weist die Anschlusseinrichtung zwei elektrische Leitungen auf, die insbesondere parallel zueinander geführt sind. Die beiden Leitungen sind jeweils mit ihren Enden an einer der beiden Basen angeschlossen. Die beiden Komponenten sind daher über die beiden zwei elektrischen Leitungen und über die Anschlussterminals miteinander verbunden. Bei den beiden Leitungen handelt es sich insbesondere um Gleichstromleitungen.

Bei dieser Ausführungsvariante mit den zwei elektrischen Leitungen weist die eine Basis den Verbindungskanal auf, über den die beiden Fluidleitungen der beiden elektrischen Leitungen miteinander verbunden sind. Die andere Basis weist zwei Versorgungskanäle auf, wobei an jedem der Versorgungskanäle jeweils über eine erste hydraulische Schnittstelle eine der Fluidleitungen der beiden Leitungen angeschlossen ist und im montierten Zustand ergänzend jeweils eine Versorgungsleitung über jeweils eine zweite hydraulische Schnittstelle. Die beiden Versorgungleitungen bilden einen Vorlauf und einen Rücklauf der Kühlmittelversorgung.

Gemäß einem eigenen erfinderischen Aspekt nach Anspruch 11 ist die Leitung als eine geschirmte Leitung ausgebildet, welche eine Schirmlage aufweist. Diese ist üblicherweise als eine Zwischenlage zwischen dem Leiter und dem Leitungsmantel ausgebildet. Zwischen der Schirmlage und Leiter ist eine zusätzliche Isolierlage insbesondere in Form eines extrudierten Zwischenmantels ausgebildet.

Die Ausgestaltung als geschirmte Leitung ist insbesondere unabhängig von der Ausbildung des Anschlussterminals mit den beiden hydraulischen Schnittstellen und dem in der Basis ausgebildeten Fluidkanal. Bevorzugt ist die Ausgestaltung als geschirmte Leitung kombiniert mit den zuvor beschriebenen Ausgestaltungen und Varianten.

Unter Schirmlage wird eine Lage verstanden, welche geeignet für eine elektrische oder magnetische Abschirmung ist, und zwar insbesondere eine Abschirmung der Leiterlage nach außen. Die Schirmlage ist beispielsweise als ein Geflecht oder eine Folie ausgebildet.

Insgesamt ist durch das Anschlussterminal eine hybride Schnittstelle einer kühlbaren und zusätzlich geschirmten Leitung ausgebildet.

Im Hinblick auf eine möglichst durchgängige Abschirmung ist hervorzuheben, dass die Fluidleitung einseitig aus der elektrischen Leitung herausgeführt ist, sodass also die Schirmlage nicht seitlich unterbrochen werden muss. Dies ist für eine möglichst durchgehende Schirmung von Vorteil.

Im Hinblick auf eine möglichst durchgehende Schirmung ist in bevorzugter Ausgestaltung die Schirmlage mit einem Schirmgehäuse elektrisch kontaktiert.

Das Schirmgehäuse ist bei einer ersten Ausführungsvariante ein separates Gehäuse, welches zusätzlich zum Terminalgehäuse ausgebildet ist. Das Schirmgehäuse und das Terminalgehäuse liegen beispielsweise unmittelbar aneinander an, ohne dass weitere Komponenten zwischen diesen beiden Gehäusen angebracht sind. Sie können auch ein gemeinsames, mehrlagiges Gehäuse bilden.

Alternativ hierzu wird das Schirmgehäuse durch das Terminalgehäuse direkt gebildet.

Das Schirmgehäuse ist allgemein geeignet ausgebildet, um die gewünschte Schirmwirkung zu erzielen. Bevorzugt besteht es aus Metall und insbesondere aus Aluminium. In einer bevorzugten Ausgestaltung besteht sowohl das Terminalgehäuse als auch die Basis jeweils aus Metall, insbesondere Aluminium und das Terminalgehäuse bildet zugleich das Schirmgehäuse. Durch diese Maßnahme ist eine besonders gute kombinatorische Wirkung aus durchgehender Schirmung und aktiver Kühlung erreicht.

Bevorzugt weist das Schirmgehäuse zumindest eine verschließbare Revisionsöffnung auf, wobei diese im geschlossenen Zustand vorzugsweise mithilfe eines Schirmelements überdeckt und verschlossen ist, sodass insgesamt eine vollständig durchgehende Schirmung erreicht ist. Dieses Schirmelement kann im Falle einer Revision entnommen und anschließend wieder angebracht werden. Über die Revisionsöffnung ist insbesondere eine Klemme, speziell eine Klemmschraube zugänglich, über die beispielsweise der Leiter geklemmt wird. Alternativ und insbesondere ergänzend ist eine weitere Klemme (Klemmschraube) zugänglich, über die der Fluidschlauch am Fluidstutzen zuverlässig fixiert ist. Speziell ist über die Revisionsöffnung, also allgemein eine Öffnung, ein Werkzeug, insbesondere ein Schraubwerkzeug einführbar, so dass zwei (Verbindungs-) Partner z.B. über eine Schraubverbindung miteinander verbunden werden können.

Bevorzugt ist der Leiter - allgemein für alle vorliegend beschriebenen Varianten - und wie bereits ausgeführt innerhalb des Terminalgehäuses über einen Kontaktverbinder elektrisch mit dem Anschlussleiter verbunden, welcher durch die Basis hindurchgeführt ist. Dieser Kontaktverbinder weist insbesondere eine Klemme, beispielsweise eine Klemmschelle auf, über die der Leiter geklemmt ist. Hierzu ist im Endabschnitt der Leitung üblicherweise als ein Widerlager eine Widerlagerhülse angebracht, wobei zwischen dem Widerlager und der Klemme des Leiters eingeklemmt ist. Das Widerlager ist insbesondere zwischen dem Fluidschlauch und dem Leiter eingezogen.

Vorzugsweise ist ein Anschlussbereich, innerhalb dessen der Kontaktverbinder und der Endabschnitt der elektrischen Leitung angebracht ist, ergänzend noch in einem Isoliergehäuse eingehaust, welches von dem Terminalgehäuse umschlossen ist.

Bevorzugt sind innerhalb des Schirmgehäuses der Kontaktverbinder sowie der Anschlussleiter angeordnet und das Schirmgehäuse ist mit der Basis verbunden. Hierdurch ist der gesamte Anschlussraum innerhalb des Terminalgehäuses von dem Schirmgehäuse umgeben, sodass eine vollständige Abschirmung erzielt ist.

Bevorzugt ist die erste hydraulische Schnittstelle, an der die Fluidleitung angeschlossen ist, innerhalb des Schirmgehäuses angeschlossen. Weiterhin ist der die beiden hydraulischen Schnittstellen verbindende Fluidkanal innerhalb der Basis und/oder auf der dem Schirmgehäuse abgewandten Seite der Basis ausgebildet. Durch diese Ausgestaltung ist gewährleistet, dass die Abschirmung nicht durch die Fluidleitung und/oder den Fluidkanal unterbrochen ist und dennoch eine beispielsweise seitliche Anschlussmöglichkeit an eine Kühlmittelversorgung über die zweite hydraulische Schnittstelle Anschlussstutzen ermöglicht ist.

Wie bereits zuvor erwähnt ist die zumindest eine elektrische Leitung als eine einadrige und/oder mehradrige Mantelleitung zur Übertragung von elektrischer Leistung von mehr als 100 kW ausgebildet. Beispielsweise ist sie zur Übertragung von elektrischen Leistungen von zumindest 300 kW und bis zu 3000 kW ausgebildet. Sie ist dabei üblicherweise auch für Spannungslagen von mehr als 100 V, beispielsweise von zumindest 400 V oder auch von zumindest 800 V und beispielsweise bis zu 1500 V ausgebildet. Gleichzeitig ist sie zur Übertragung von hohen Strömen von zumindest 100A oder von zumindest 500A ausgebildet.

Bei der angeschlossenen elektrischen Komponente handelt es sich bevorzugt um eine in einem Fahrzeug angeordnete Komponente, beispielsweise um einen Leistungsverteiler, um eine Sicherungsbox, um eine (Fahr-) Batterie oder um einen Wechselrichter zur Umwandlung von Gleichstrom in Wechselstrom, welcher einem elektrischen Fahrmotor für das elektrische Fahrzeug vorgeschalteten ist oder auch um einen elektrischen Verbraucher, wie beispielsweise der Fahrmotor.

Bei der Ausführungsvariante mit den beiden Anschlussterminals, die über die zumindest eine elektrische Leitung miteinander verbunden sind, ist das eine Anschlussterminal vorzugsweise an einem Leistungsverteiler und das andere Anschlussterminal an einer weiteren elektrischen Komponente, wie beispielsweise an einem Leistungsverteiler, Sicherungsbox, Batterie, Wechselrichter oder elektrische Verbraucher wie beispielsweise Fahrmotor angeschlossen.

Wie zuvor bereits erläutert, bildet die Basis vorzugsweise eine Gehäusewand eines Komponentengehäuses der Komponente aus oder ist zumindest ein Teil einer solchen Gehäusewand, die nachfolgend auch als erste Gehäusewand bezeichnet wird.

In bevorzugter Weiterbildung ist in einer zweiten, von der ersten Gehäusewand verschiedenen Gehäusewand, insbesondere eine zu der ersten Gehäusewand winklig orientierte Gehäusewand, eine Kühlstruktur ausgebildet. An der zweiten hydraulischen Schnittstelle ist vorzugsweise eine Verbindungsleitung angeschlossen, die mit der Kühlstruktur verbunden ist, so dass also das Kühlmittel aus der ersten Gehäusewand heraus in die zweite Gehäusewand zu der dort ausgebildeten Kühlstruktur geführt werden kann. Dies ist insbesondere dann von Vorteil, wenn die Basis und das Anschlussterminal z.B. an einer Seitenwand (als erste Gehäusewand) angeschlossen ist und ein Boden (als zweite Gehäusewand) des Komponentengehäuses über eine integrierte Kühlstruktur gekühlt werden soll. Über die Verbindungsleitung, die vorzugsweise außerhalb des Komponentengehäuses verläuft, können daher die beiden Gehäusewände einfach miteinander verbunden werden. Die Verbindungsleitung ist z.B. als Verbindungsschlauch oder Verbindungsrohr ausgebildet. Alternativ kann auch der in der Basis integrierte Fluidkanal als integraler Bestandteil der Gehäusewände von der ersten Gehäusewand in die zweite Gehäusewand geführt werden, jedoch ist dies üblicherweise fertigungstechnisch aufwändig.

Ein Ausführungsbeispiel der Erfindung wird nachfolgend anhand der Figuren näher erläutert. Diese zeigen in teilweise vereinfachten Darstellungen:
- FIG 1: eine Darstellung einer elektrischen Anschlusseinrichtung mit zwei elektrischen Leitungen, die beidseitig jeweils an einer gemeinsamen Basis angeschlossen sind,
- FIG 2: eine Explosionsdarstellung auf die Anordnung gemäß FIG 1 mit anderer Blickrichtung,
- FIG 3: eine vergrößerte ausschnittsweise Darstellung der linken Bildhälfte von FIG 2 , wobei einige bei dem einen Anschlussterminal einige Komponenten ausgeblendet sind
- FIG 4: eine vergrößerte ausschnittsweise Darstellung der linken Bildhälfte von FIG 1,
- FIG 5A: eine perspektivische Außenansicht auf ein ausschnittsweise dargestelltes Komponentengehäuse mit zwei jeweils über ein Anschlussterminal daran angeschlossenen Leitungen,
- FIG 5B: eine perspektivische Innenansicht auf das in FIG 5A dargestellte Komponentengehäuse,
- FIG 6A: eine perspektivische Außenansicht auf ein ausschnittsweise dargestelltes Komponentengehäuse mit zwei jeweils über ein Anschlussterminal daran angeschlossenen Leitungen sowie mit zwei Verbindungsleitungen, die zu einer zweiten Gehäusewand führen,
- FIG 6B: eine perspektivisch Innenansicht auf das in FIG 6A dargestellte Komponentengehäuse sowie
- FIG 7: eine ausschnittsweise Darstellung auf ein Komponentengehäuse mit zwei winklig angeschlossenen Leitungen.

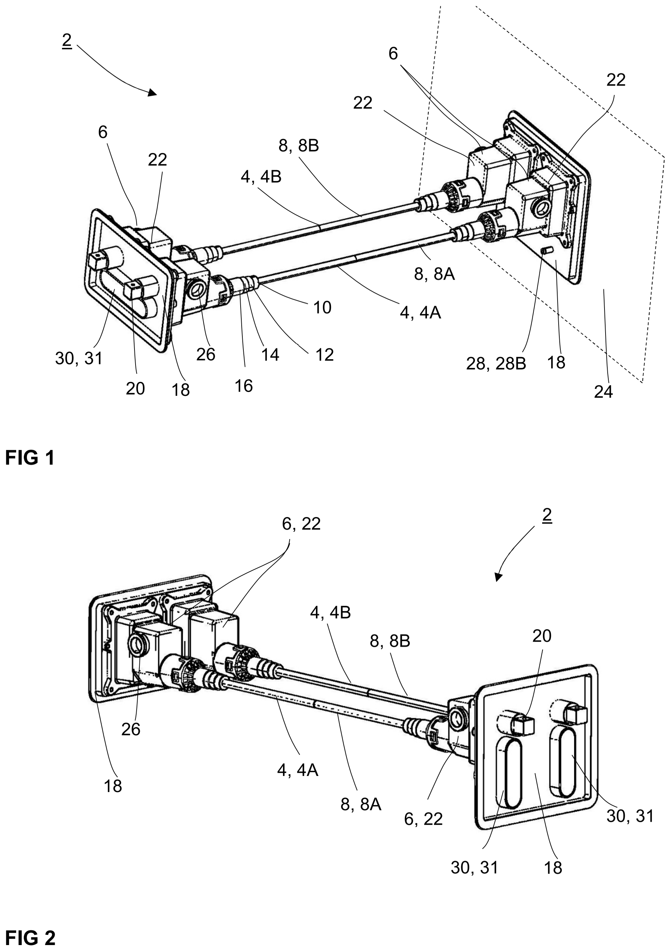

FIG 1 zeigt eine elektrische Anschlusseinrichtung 2 mit zwei elektrischen und geschirmten Leitungen 4 (erste Leitung 4A, weitere (zweite) Leitung 4B), die beidseitig jeweils über ein Anschlussterminal 6 gemeinsam an einer gemeinsamen Basis 18 angeschlossen sind und die zwei elektrische Komponenten 24 miteinander verbinden. In FIG 1 ist lediglich auf der rechten Bildhälfte eine Gehäusewand der Komponente 24 gestrichelt dargestellt.

Die beiden Basen 18 sind im Ausführungsbeispiel unterschiedlich ausgebildet. Die in den Figuren 1, 2 auf der linken Bildhälfte dargestellte Basis 18 ist als eine Verbindungs-Basis mit einem als Verbindungskanal ausgebildeten Fluidkanal 30 und die auf der rechten Bildhälfte dargestellte Basis 18 ist als eine Versorgungsbasis zum zwei als Versorgungskanäle ausgebildete Fluidkanäle 30 ausgebildet, wie nachfolgend noch näher im Detail erläutert wird.

Eine jeweilige Leitung 4 ist jeweils identisch aufgebaut und weist jeweils eine Fluidleitung auf, die im Ausführungsbeispiel als ein zentraler Fluidschlauch 8 (erster Fluidschlauch 8A, weiterer (zweiter) Fluidschlauch 8B) ausgebildet ist, welcher insbesondere unmittelbar von einer elektrischen Leiterlage 10 umgeben ist, welche einen elektrischen Leiter der Leitung 4 bildet. Diese Leiterlage 10 ist beispielsweise durch einen metallischen Geflechtschlauch gebildet oder auch durch mehrere einzelne Leiterstränge gebildet, die insbesondere schraubenförmig um den Fluidschlauch 8 gewickelt sind. Die Leiterstränge sind beispielsweise als Litzenleiter ausgebildet. Sie liegen insbesondere unmittelbar aneinander an, so dass diese einen umfangsseitig geschlossenen Leitermantel bilden. Die Leiterstränge sind einlagig oder auch mehrlagig angeordnet. Die Leiterlage 10 ist nachfolgend zunächst von einem elektrisch isolierenden Zwischenmantel 12 umgeben, welcher wiederum von einer Schirmlage 14 umgeben ist. Diese ist beispielsweise als Folie oder als Geflecht ausgebildet. Um diese herum ist schließlich ein äußerer, elektrisch isolierender Leitungsmantel 16 angebracht.

In den Figuren ist von der jeweiligen Leitung 4 in einem mittigen Bereich zwischen den Anschlussterminals 6 jeweils lediglich der zentrale Fluidschlauch 8 dargestellt.

Die Anschlussterminals 6 der beiden Leitungen 4 sind jeweils an der gemeinsamen Basis 18 angeschlossen, die im Ausführungsbeispiel als ein plattenförmiges Element ausgebildet bzw. dargestellt ist. Die Basis 18 besteht bevorzugt aus Metall, speziell aus Aluminium. Die Basis 18 ist insbesondere als ein monolithisches Gussbauteil ausgebildet. Die Basis 18 weist Durchbrüche auf, durch die jeweils ein Anschlussleiter 20 hindurchgeführt ist. Der Anschlussleiter 20 ist im Ausführungsbeispiel als ein massiver Leiterstab mit beispielsweise rechteckförmiger und insbesondere quadratischer Querschnittsfläche ausgebildet.

Die jeweilige Basis18 ist insbesondere Teil einer Gehäusewand eines jeweiligen Komponentengehäuses der beiden Komponente 24, die über die Leitungen 4 miteinander verbunden sind. Die Basis 18 ist also in diesem Fall unmittelbar ein Teilstück dieser Gehäusewand der elektrischen Komponente 24, bildet also ein Teilstück des Komponentengehäuses aus.

Ein jeweiliges Anschlussterminal 6 weist im Ausführungsbeispiel für jede Leitung 4 jeweils ein Terminalgehäuse 22 auf. Der Aufbau der Terminalgehäuse 22 ist insbesondere identisch.

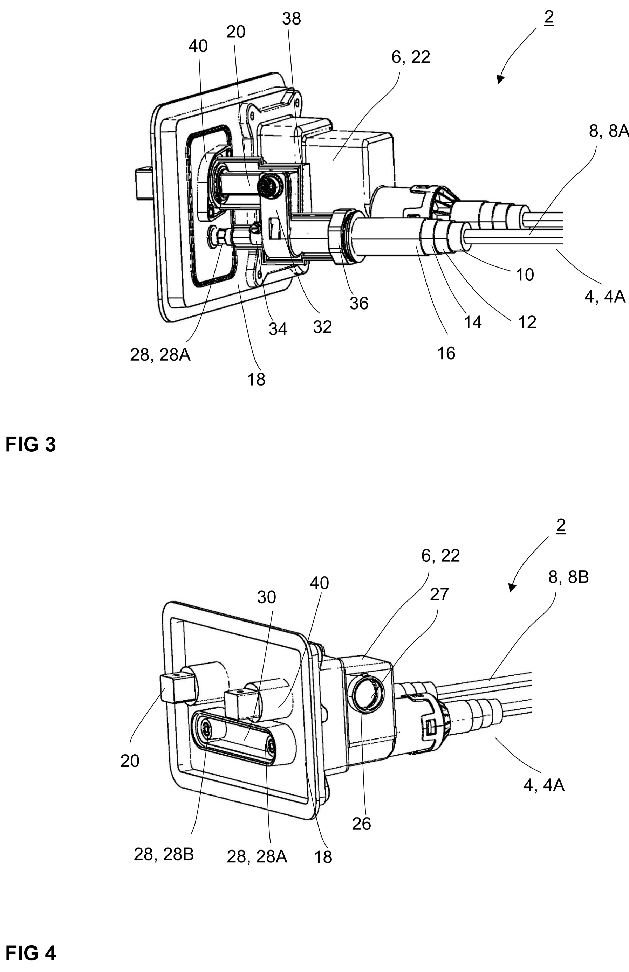

Das jeweilige Terminalgehäuse 22 ist mit der Basis 18 in geeigneter Weise verbunden. Im Ausführungsbeispiel weist das Terminalgehäuse 22 endseitig einen Befestigungsflansch auf, über den eine Befestigung, insbesondere Schraubbefestigung an der Basis 18 erfolgt. Wie nachfolgend noch insbesondere in Verbindung mit FIG 3 näher erläutert wird, wird die jeweilige Leiterlage 10 mittels einer Schraubkontaktierung mit dem Anschlussleiter 20 verbunden.

Alternativ zu einer solchen Schraubverbindung besteht grundsätzlich auch die Möglichkeit, eine Steckverbindung vorzusehen, bei der also die elektrische Verbindung zwischen der Leiterlage 10 und dem Anschlussleiter 20 und/oder die mechanische Verbindung zwischen dem Terminalgehäuse 22 und der Basis 18 über eine Steckverbindung erfolgt.

Das Terminalgehäuse 22 weist im Ausführungsbeispiel jeweils einen Anschlussstutzen auf, durch welchen die jeweilige Leitung 4 mit einem Endabschnitt in das Innere des Terminalgehäuses 22 hineingeführt wird. Innerhalb des Terminalgehäuses 22 erfolgt die elektrische Kontaktierung der Leiterlage 10 mit dem Anschlussleiter 20 sowie der Schirmlage 14 mit einem Schirmgehäuse, welches im Ausführungsbeispiel durch das Terminalgehäuse 22 ausgebildet ist. Dieses besteht vorzugsweise aus Metall, insbesondere aus Aluminium.

Ein jeweiliges Terminalgehäuse 22 weist weiterhin eine verschließbare Revisionsöffnung 26 auf. Über diese ist beispielsweise die Verschraubung für die elektrische Kontaktierung der Leiterlage 10 mit dem Anschlussleiter 20 zugänglich. Um eine durchgängige Schirmung zu gewährleisten ist innerhalb der Revisionsöffnung 26 ein Schirmelement 27 angebracht, welches die Revisionsöffnung 26 überspannt und verschließt (vgl. FIG 4). Das Schirmelement 27 kann bei Bedarf entfernt und beispielsweise nach einer Revisionsmaßnahme wieder eingesetzt werden.

Die verschiedenen Komponenten der Anschlusseinrichtung 2 sind jeweils zueinander abgedichtet, sodass keine Feuchtigkeit / kein Wasser von außen über die Anschlussterminals 6 in die elektrische Komponente 24 gelangen kann. Die Abdichtmaßnahmen betreffen hierbei insbesondere die Einführung der jeweiligen Leitung 4 in das jeweilige Terminalgehäuse 22 und/oder den Durchtritt des Anschlussleiters 20 durch die Basis 18 und/oder einen dichtenden Anschluss des Terminalgehäuses 22 an der Basis 18, beispielsweise über eine umlaufende Ringdichtung.

Als ein besonderer Aspekt der Anschlusseinrichtung 2 ist die Anschlussmöglichkeit an einen Kühlkreislauf und damit eine aktive Kühlung der kompletten Anschlusseinrichtung 2 hervorzuheben.

Wie insbesondere anhand der teilweise freigelegten Darstellung gemäß FIG 3 zu erkennen ist, ist eine jeweilige Leitung 4 mit ihrem Ende an einer hydraulische Schnittstelle angeschlossen, die im Ausführungsbeispiels als ein Fluidstutzen 28 ausgebildet ist.. Dieser ist beispielsweise als ein monolithisches Teilstück der Basis 18 ausgebildet oder alternativ als ein separates Bauteil, welches z.B. in einen Stutzenöffnung der Basis 18 eingesteckt werden kann. Er befindet sich innerhalb des Innenraums des Terminalgehäuses 22.

Eine jeweilige Basis 18 weist zumindest zwei Fluidstutzen 28 auf, nämlich einen ersten Fluidstutzen 28A und einen zweiten Fluidstutzen 28B. Diese sind über einen Fluidkanal 30 miteinander verbunden.

Der Fluidkanal 30 ist jeweils integraler Bestandteil der Basis 18 und beispielsweise als eine im plattenförmigen Element ausgeformter Fluidraum ausgebildet, welcher insbesondere zu einer Seite offen ist, welche von einem Deckel 31 reversibel und dicht verschließbar ist. Anhand FIG 4, die den Fluidkanal 30 ohne Deckel 31 zeigt, ist gut zu erkennen, dass die beiden Fluidstutzen 28A, 28B im Ausführungsbeispiel gemeinsam in diesen Fluidkanal 30 münden, sodass eine Fluidverbindung zwischen den beiden Fluidstutzen 28A, 28B ausgebildet ist. Im Ausführungsbeispiel ist der Fluidkanal 30 an der dem Terminalgehäuse 22 abgewandten Rückseite der Basis 18 ausgeformt.

Bei dem auf der linken Bildhälfte der Figuren 1 und 2 sowie in den Figuren 3 und 4 dargestellten Basis 18 sind lediglich zwei Fluidstutzen 28A, 28B ausgebildet, welche über den Fluidkanal 30 miteinander verbunden sind. Über diesen wird daher ein über die eine (erste) Leitung 4A einströmendes Kühlmittel innerhalb der Basis 18 umgelenkt und über den weiteren (zweiten) Fluidstutzen 28B wieder in die weitere (zweite) Leitung 4B eingespeist. Dieser Fluidkanal 30 wir daher auch als Verbindungskanal und die Basis 18 entsprechend als Verbindungsbasis bezeichnet.

Bei der auf der rechten Bildhälfte der Figuren 1 und 2 dargestellten Basis 18 sind demgegenüber insgesamt vier Fluidstutzen 28 an der Basis angebracht, und zwar vorzugsweise alle an der dem Terminalgehäuse 22 zugewandten Vorderseite der Basis 18. Neben den beiden Fluidstutzen 28A, an denen die beiden Fluidschläuche 8A, 8B angeschlossen sind und die in diesem Fall jeweils den ersten Fluidstutzen 28A bilden, sind zwei weitere als Anschlussstutzen 28B bezeichnete Fluidstutzen integriert, die jeweils den zweiten Fluidstutzen 28B bilden. Von diesen ist in der FIG 1 lediglich einer zu erkennen.

Die beiden Anschlussstutzen 28B sind hierbei jeweils außerhalb der Terminalgehäuse 22 angeordnet und damit von außen frei zugänglich. An diese Anschlussstutzen 28B sind weitere Fluidschläuche 8B (hier nicht weiter dargestellt) anschließbar, die insbesondere zu einer Kühlmittelversorgung, beispielsweise zu einer Kühlmittelpumpe führen. Diese weiteren Fluidschläuche 8B werden daher auch als Kühlmittel-Versorgungsleitungen bezeichnet.

Die als Versorgungsbasis ausgebildete Basis 18 weist entsprechend auch zwei Fluidkanäle 30 auf, die jeweils einen der ersten Fluidstutzen 28A mit einem der zweiten Fluidstutzen 28B strömungstechnisch verbinden.

Über den einen Anschlussstutzen 28B wird daher an die Versorgungsbasis eine Vorlauf-Versorgungsleitung angeschlossen, über die das Kühlmittel mittels des einen Versorgungskanals in den ersten Fluidschlauch 8A eingespeist wird. Das Kühlmittel wird dann an der Verbindungsbasis über den dortigen Fluidkanal 30 (Verbindungskanal) in den zweiten Fluidschlauch 8B eingespeist und über diesen wieder zu der Versorgungsbasis zurückgeführt. Das Kühlmittel wird schließlich über den dort ausgebildeten weiteren Fluidkanal 30 (zweiter Versorgungskanal) dem weiteren Anschlussstutzen 28B zugeführt und verlässt die Versorgungsbasis über eine Rücklauf-Versorgungsleitung. Insgesamt ist daher das Kühlmittel durch diese spezielle Ausgestaltung zwischen den beiden Basen 18 und damit zwischen den beiden Komponenten 24 in einem Kreislauf geführt.

Bei der in den Figuren dargestellten Variante sind die hydraulischen Schnittstellen (Fluidstutzen 8) jeweils an einer gemeinsamen Anschlussseite der Basis 18 und damit auch der Komponente 24 ausgebildet. D.h. insbesondere sind die hydraulischen Schnittstellen an einer gemeinsamen Gehäuseseite des Komponentengehäuses ausgebildet und typischerweise jeweils nur wenige Zentimeter voneinander entfernt.

Alternativ hierzu sind die hydraulischen Schnittstellen an verschiedenen Gehäuseseiten, beispielsweise an gegenüberliegenden Gehäuseseiten oder auch an benachbarten Gehäuseseiten angebracht, so dass also die hydraulischen Schnittstellen, insbesondere die ersten hydraulischen Schnittstellen, an denen die Fluidleitungen der elektrischen Leitungen angeschlossen sind, an verschiedenen Gehäuseseiten angebracht sind. In einer weiteren Variante sind die Schnittstellen in voneinander beabstandeten Randbereichen einer gemeinsamen Gehäuseseite angebracht.

Die hydraulischen Schnittstellen sind daher hierbei allgemein insbesondere entfernt zueinander angeordnet. Beispielsweise sind mehrere Komponenten 24 (mehr als 2) seriell über die Fluidleitungen in den Kühlkreislauf eingebunden.

Insbesondere (aber nicht zwingend) bei diesen Varianten mit den entfernt zueinander angeordneten Schnittstellen verläuft in bevorzugter Ausgestaltung der integrierte Fluidkanal 30 über ein größeres Teilstück von z.B. mehr als 10 cm innerhalb der Basis 18 und damit insbesondere auch innerhalb des Komponentengehäuses. Bei einer solchen Variante ist der Fluidkanal 30 beispielsweise Teil einer flächigen Kühlstruktur und verläuft beispielsweise mäanderförmig und erstreckt sich z.B. über weite Flächenbereich der Gehäusewand.

In der ausschnittsweise Darstellung der FIG 3 ist das linke Terminalgehäuse 22 entfernt, sodass verschiedene Anschlusskomponenten zu erkennen sind.

Für den elektrischen Anschluss der Leiterlage 10 an den Anschlussleiter 20 ist ein Kontaktverbinder 32 angebracht, welcher nach Art einer Klemmschelle ausgebildet ist. Diese umgreift zunächst die Leiterlage 10 und liegt an dieser klemmend und elektrisch kontaktierend an. Die Klemmschelle umgreift die Leiterlage 10 vollumfänglich und weist im Ausführungsbeispiel zwei parallel zueinander geführte Laschen auf, die zu dem Anschlussleiter 20 geführt sind, wo der Kontaktverbinder 32 mit dem Anschlussleiter 20 über eine Schraube mechanisch und elektrisch verbunden ist. Zwischen dem jeweiligen Fluidschlauch 8 und der Leiterlage 10 ist hierbei jeweils eine mechanisch steife Unterziehhülse angebracht, die ein Widerlager ausbildet.

Der jeweilige Fluidschlauch 8 ist vorzugsweise über eine Crimpverbindung am Fluidstutzen 28 befestigt. Alternativ ist der jeweilige Fluidschlauch 8 jeweils über eine Klemmschelle 34 und über eine Schraube klemmend mit dem jeweiligen Fluidstutzen 28 angeschlossen.

Die jeweiligen Schrauben des Kontaktverbinders 32 und der Klemmschelle 34 sind jeweils über eine eigene Revisionsöffnung 26 zugänglich, wie sie zuvor beschrieben wurde.

Weiterhin ist die Schirmlage 14 mit dem Terminalgehäuse 22 elektrisch leitend verbunden, welches zugleich ein Schirmgehäuse ausbildet. Hierzu wird die Schirmlage 14 ebenfalls insbesondere klemmend kontaktiert und zwar im Ausführungsbeispiel über ein ringförmiges Crimpelement 36, welches also elektrisch und mechanisch mit der Schirmlage 14 verbunden ist. Auch hier ist wiederum als Widerlager bevorzugt eine Unterziehhülse angebracht. Der zuvor bereits beschriebene Anschlussstutzen des Terminalgehäuses 22, durch den die Leitung 4 eingeführt wird, wird auf dieses Crimpelement 36 aufgeschoben, sodass das Crimpelement 36 nach Art einer Presspassung klemmend innerhalb dieses Anschlussstutzens zuverlässig elektrisch kontaktiert ist. Das Crimpelement 36 weist hierzu an seinem Umfang insbesondere Kanten aus, die beim Crimpvorgang ausgebildet sind, und die beispielsweise in die Gehäusewand des Terminalgehäuses 22 einschneiden oder zumindest für eine zuverlässige Presspassung sorgen.

Das Terminalgehäuse 22 ist wiederum mit einem Anschlussflansch mit der Basis 18 elektrisch kontaktiert, sodass also insgesamt eine vollständige und zuverlässige Abschirmung des Anschlussbereichs innerhalb des Terminalgehäuses 22 ausgebildet ist.

Im Ausführungsbeispiel ist ergänzend zu dem Terminalgehäuse 22 noch ein Isoliergehäuse 38 angeordnet. Dieses ist beispielsweise in zwei Schalenhälften unterteilt, von denen in FIG 3 die Hintere zu erkennen ist. Das Isoliergehäuse 38 umgibt einen Anschlussbereich, in dem der Kontaktverbinder 32 angeordnet ist. Der Fluidstutzen 28 ist bevorzugt außerhalb des Isoliergehäuses 38, jedoch innerhalb des Terminalgehäuses 22 angeordnet. Das Isoliergehäuse 38 isoliert daher die stromführenden Bauteile gegenüber des Terminalgehäuses 22. Das Isoliergehäuse 38 reicht bis zur Basis 18 bzw. im Ausführungsbeispiel bis zu einer Isolierdurchführung 40. Es erstreckt sich vorzugsweise ausgehend von dem Crimpelement 36, umgibt also zunächst hülsenförmig das Leitungsende der Leitung 4, und folgt anschließend dem - im Ausführungsbeispiel L-förmigen - Verlauf des Kontaktverbinders 32.

Die Isolierdurchführung 40 umgibt den Anschlussleiter 20 und isoliert diesen daher gegenüber der Basis. Die Isolierdurchführung 40 weist auf der Seite des Terminalgehäuses 22 ein Kopfteil auf, mit dem es auf der einen Seite der Basis 18 aufliegt (vgl. FIG 3). An das Kopfteil schließt sich ein Hülsenteil an, das zumindest weitgehend passgenau durch eine Durchtrittsöffnung in der Basis 18 geführt (gesteckt) ist, und in dem der - im Ausführungsbeispiel stabförmige - Anschlussleiter 20 vorzugsweise ebenfalls passgenau geführt ist (vgl. FIG 4). Das Isoliergehäuse 38 stützt sich an dem Kopfteil endseitig mit seinen Gehäusewänden ab. Die Isolierdurchführung ist insbesondere ein monolithisches Gussbauteil.

Die Verwendung einer geschirmten kühlbaren Leitung 4A, 4B und der Anschluss der Schirmlage 14 insbesondere derart, dass die Schirmung unterbrechungsfrei ist, wird als ein weiterer besonderer Aspekt der hier beschriebenen Anschlusseinrichtung angesehen.

Die hier in der Figurenbeschreibung verwendeten Begriffe "Fluidschlauch" "Fluidstutzen" sowie "Leiterlage" bezeichnen eine besondere Ausführungsvariante, gelten allgemein jedoch ohne Beschränkung der Allgemeinheit als Synonyme für "Fluidleitung", "hydraulische Schnittstelle" sowie "Leiter".

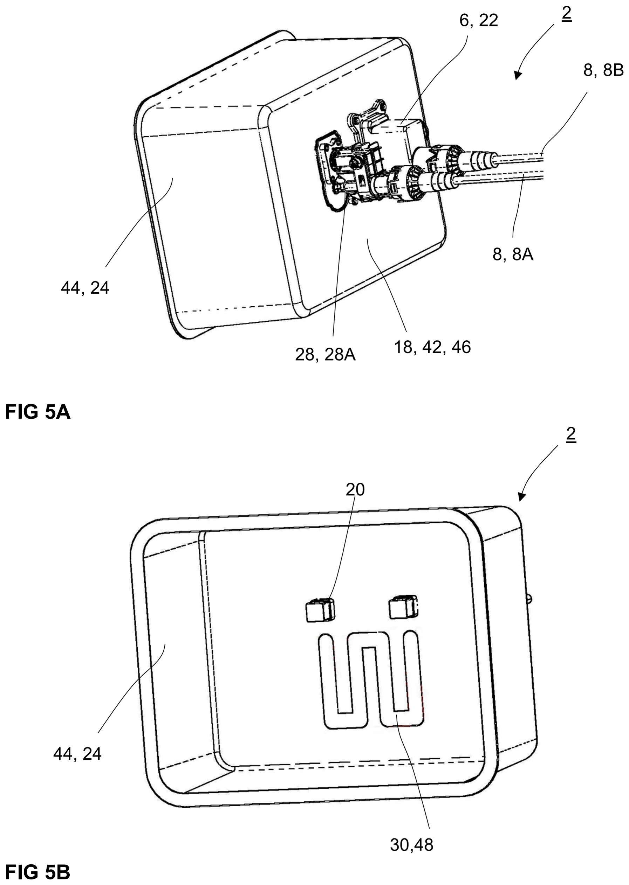

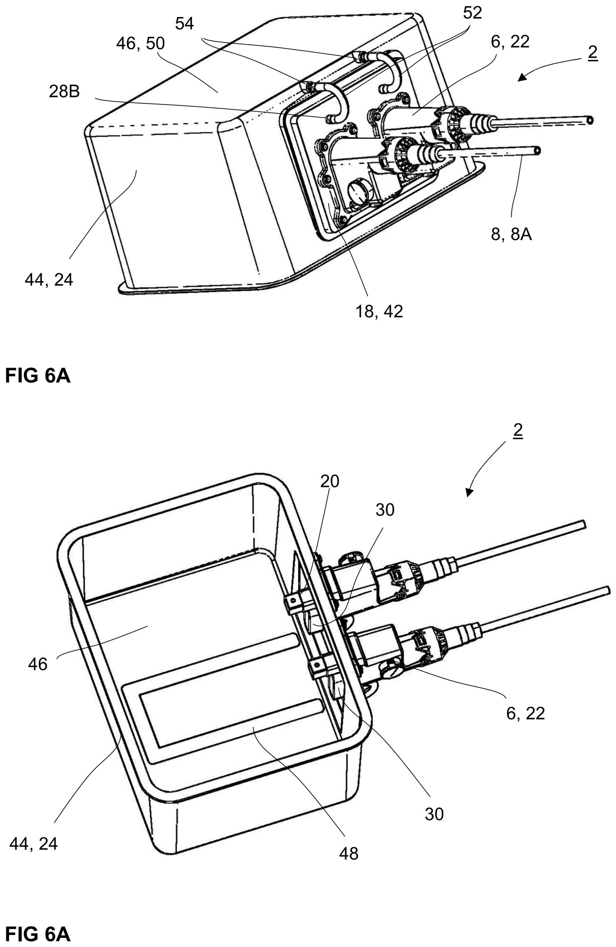

Anhand der Figuren 5A, 5B sowie 6A, 6B sind zwei Varianten dargestellt, bei denen die Basis 18 jeweils zumindest Teil einer (ersten) Gehäusewand 42 eines Komponentengehäuses 44 der Komponente 24 bildet. Dargestellt ist in diesen Figuren jeweils nur ein Teil des Komponentengehäuses 44, beispielsweise ein Bodenteil oder ein Deckelteil. Dieses weist jeweils mehrere Seitenwände sowie einen Boden 46 auf.

Bei Figur 5A ist bei dem auf der linken Bildhälfte dargestellte Anschlussterminal 6 das Terminalgehäuse 22 sowie ein Teil des Isoliergehäuses 38 ausgeblendet, so dass der Blick auf die innenliegenden Komponenten des Anschlussterminals 6 freigegeben ist, wie sie zuvor z.B. bereits im Zusammenhang mit der FIG 3 beschrieben wurden.

Der die beiden hydraulischen Schnittstellen 28A, 28B (nur 28A zu erkennen) verbindende Fluidkanal 30 bildet eine Kühlstruktur 48 aus, die in der ersten Gehäusewand 42 und damit in der Basis 18 ausgebildet ist. Diese weist insbesondere einen mäanderförmig verlaufenden Kanal aus, welcher den Fluidkanal 30 bildet (vgl. hierzu FIG 5B). Die erste Gehäusewand 42 und damit die Basis 18 ist hier insbesondere durch den Boden 46 gebildet, so dass dieser im Betrieb gekühlt wird.

Bei der Variante gemäß den FIG 6A, FIG 6B ist die erste Gehäusewand 42 demgegenüber durch eine Seitenwand gebildet. Gleichzeitig ist die Kühlstruktur 48 innerhalb des Bodens 46 ausgebildet, also allgemein innerhalb einer zweiten Gehäusewand 50, die insbesondere winklig und speziell rechtwinklig zu der ersten Gehäusewand 42 orientiert ist und sich bevorzugt an diese über eine Gehäusekante anschließt.

Um mit geringem konstruktivem Aufwand im Betrieb Kühlmittel durch die Kühlstruktur 48 strömen zu lassen, ist an einer jeweiligen zweiten hydraulischen Schnittstelle 28B jeweils eine Verbindungsleitung 52 angeschlossen, welches die insbesondere als Fluidstutzen ausgebildete zweite hydraulische Schnittstelle 28B mit einer weiteren hydraulischen Schnittstelle 54 verbindet, welche mit der Kühlstruktur 48 strömungstechnisch verbunden ist. Die weitere hydraulische Schnittstelle ist beispielsweise wiederum durch einen Fluidstutzen gebildet. Die Verbindungsleitung 52 ist im Ausführungsbeispiel außerhalb des Komponentengehäuses 44 geführt. Die Verbindungsleitungen sind als gebogene Leitungen, insbesondere U-förmig gebogene Leitungen ausgebildet.

Durch diese Maßnahme ist die im Boden 46 ausgebildete Kühlstruktur 48 in den Kühlmittelkreislauf eingebunden. Die Kühlstruktur 48 gemäß der Variante nach FIG 6B ist wiederum (wie auch die der Variante nach FIG 5B) insbesondere als eine in den Boden 46 integrierte Kühlstruktur 48 ausgebildet, d.h. in dem Boden 46 selbst sind Kühlkanale ausgeformt. Die Kühlstruktur 48 ist in FIG 5B U-förmig dargestellt. Der Verlauf der einzelnen Kanalabschnitte der integrierten Kühlstruktur 48 ist jedoch hierauf nicht beschränkt.

Jede der in FIG 6A zu erkennenden zweiten hydraulischen Schnittstellen 28B ist jeweils über einen in der Basis 18 integrierten Fluidkanal 30 mit der jeweiligen ersten hydraulischen Schnittstelle 28A (nicht zu erkennen) verbunden.

Die Basis 18 ist in der Variante gemäß der FIG 6A beispielsweise als eine Art Anschlussplatte ausgebildet, welche ein separates Bauteil bildet, über die eine Gehäuseöffnung in der ersten Gehäusewand 42 verschlossen ist. Die Basis 18 bildet daher einen Teil der Gehäusewand 42.

In beiden Varianten gemäß den FIG 5A, 5B sowie FIG 6A, 6B wird daher der Boden 46 aktiv gekühlt. Hierdurch wird zugleich eine gute Kühlung von im Komponentengehäuse 44 angeordneten elektrischen Bauteilen erreicht. Bevorzugt sind ein oder mehrere Bauteile am Boden 46 insbesondere unmittelbar daran anliegend oder thermisch leitend über ein Thermisches Interface-Material, beispielsweise über ein Wärmeleitpad angeordnet. Beispielsweise ist am Boden 46 und insbesondere im Bereich der integrierten Kühlstruktur 48 eine Leiterplatte und / oder eine Stromschiene und / oder eine andere zu kühlende Komponente und / oder Bauteil angeordnet.

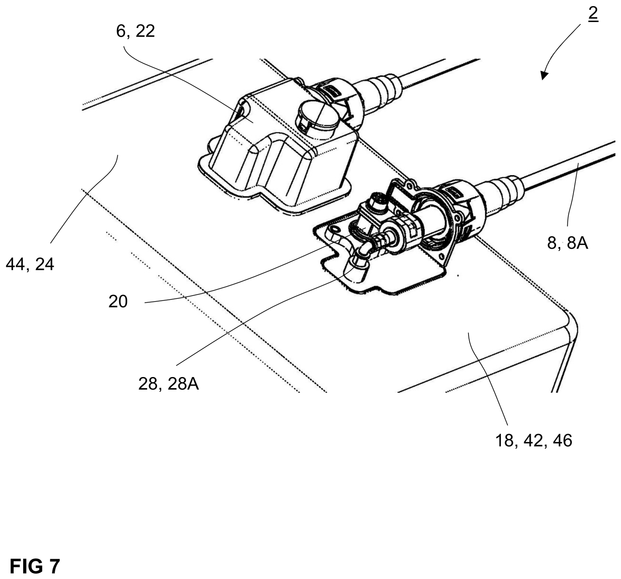

FIG 7 zeigt eine Variante wie FIG 5A, FIG 5B, allerdings mit dem Unterschied, dass die Leitungen 4A, 4B nicht senkrecht zu der Basis 18 und der ersten Gehäusewand 42 zugeführt werden, sondern seitlich. Das jeweilige Anschlussterminal 6 ist hierbei als ein winkliges Anschlussterminal 6 ausgebildet, bei dem also der Anschlussleiter 20 sowie auch die hydraulischen Schnittstellen 28A, 28B winklig ausgestaltet sind bzw. senkrecht zu der Längsrichtung der Leitungen 4A, 4B orientiert sind. Insbesondere sind die hydraulischen Schnittstellen 28A, 28B als winklige (90°-Winkel) Fluidstutzen ausgebildet.

Innerhalb der Basis 18 (erste Gehäusewand 42, Boden 46) ist die zu FIG 5B beschriebene Kühlstruktur 48 ausgebildet, welche durch den Fluidkanal 30 gebildet ist.

Bei dem einen Anschlussterminal 6 ist wiederum das Terminalgehäuse 22 entfernt, so dass der Blick auf die innenliegenden Komponenten freigegeben ist.

Eine derartige Ausgestaltung mit winkligen Anschlussterminals 6 ist grundsätzlich bei allen zuvor beschriebenen Varianten einsetzbar.

### Bezugszeichenliste

- 2: Anschlusseinrichtung
- 4: Leitung
- 4A: erste Leitung
- 4B: zweite Leitung
- 6: Anschlussterminal
- 8: Fluidschlauch
- 8A: erster Fluidschlauch
- 8B: zweiter Fluidschlauch
- 10: Leiterlage
- 12: Zwischenmantel
- 14: Schirmlage
- 16: Leitungsmantel
- 18: Basis
- 20: Anschlussleiter
- 22: Terminalgehäuse
- 24: elektrische Komponente
- 26: Revisionsöffnung
- 27: Schirmelement
- 28: Fluidstutzen
- 28A: erster Fluidstutzen
- 28B: zweiter Fluidstutzen (Anschlussstutzen)
- 30: Fluidkanal
- 31: Deckel
- 32: Kontaktverbinder
- 34: Klemmschelle
- 36: Crimpelement
- 38: Isoliergehäuse
- 40: Isolierdurchführung
- 42: erste Gehäusewand
- 44: Komponentengehäuse
- 46: Boden
- 48: Kühlstruktur
- 50: zweite Gehäusewand
- 52: Verbindungsleitung
- 54: weitere hydraulische Schnittstelle

## Patentansprüche

1. Elektrische Anschlusseinrichtung (2) insbesondere eines Kraftfahrzeuges mit einer kühlbaren elektrischen Leitung (4, 4A), insbesondere eine einadrige Mantelleitung zur Übertragung von elektrischen Leistungen von mehr als 100 kW, und mit einem Anschlussterminal (6), über die die elektrische Leitung (4, 4A) im montierten Zustand an einer elektrischen Komponente (24) angeschlossen ist, wobei die kühlbare elektrische Leitung (4, 4A) zumindest eine integrierte Fluidleitung (8, 8A, 8B) für ein Kühlmittel, zumindest einen elektrischen Leiter (10) zur Stromübertragung und einen isolierenden Leitungsmantel (16) aufweist, und wobei die elektrische Leitung (4, 4A) mit einem Endabschnitt in das Anschlussterminal (6) eingeführt ist, wobei das Anschlussterminal (6) ein Terminalgehäuse (22) aufweist, welches im montierten Zustand an einer Basis (18) angeschlossen ist, **dadurch gekennzeichnet, dass** die Fluidleitung (8, 8A, 8B) über eine erste hydraulische Schnittstelle (28, 28A) mit der Basis (18) verbunden ist und die Basis (18) eine zweite hydraulische Schnittstelle (28, 28B) aufweist, an der eine weitere Fluidleitung (8, 8A, 8B) zur Ausbildung eines Kühlkreislaufes zumindest anschließbar ist, wobei die beiden hydraulischen Schnittstellen (28, 28A, 28B) über einen in der Basis (18) integrierten Fluidkanal (30) verbunden sind.

2. Anschlusseinrichtung (2) nach dem vorhergehenden Anspruch, **dadurch gekennzeichnet, dass** die Basis (18) Teil einer Gehäusewand der Komponente (24) ist.

3. Anschlusseinrichtung (2) nach einem der vorhergehenden Ansprüche,
**dadurch gekennzeichnet, dass** die Basis (18) aus Metall ist und insbesondere nach Art einer Kühlplatte ausgebildet ist.

4. Anschlusseinrichtung (2) nach einem der vorhergehenden Ansprüche, **dadurch gekennzeichnet, dass** die Fluidleitung (8, 8A, 8B) durch einen zentralen Fluidschlauch gebildet ist, welcher innerhalb des Leiters (10) geführt ist und der endseitig aus dem Leiter (10) heraustritt.

5. Anschlusseinrichtung (2) nach einem der vorhergehenden Ansprüche,
**dadurch gekennzeichnet, dass** sie eine weitere elektrische Leitung (4, 4B) mit einer Fluidleitung (8, 8B) aufweist, welcher ebenfalls über eine hydraulische Schnittstelle (28, 28A, 28B) an der Basis (18) angeschlossen ist.

6. Anschlusseinrichtung (2) nach Anspruch 5, **dadurch gekennzeichnet, dass** der Fluidkanal (30) als ein Verbindungskanal ausgebildet ist und die Fluidleitung (8, 8B) der weiteren elektrischen Leitung (4, 4B) an der zweiten hydraulischen Schnittstelle (8, 8B) angeschlossen ist, wobei die zweite hydraulische Schnittstelle (28, 28B) an einer gemeinsamen Seite der Basis (18) neben der ersten hydraulische Schnittstelle (28, 28B) angeordnet ist.

7. Anschlusseinrichtung (2) nach einem der Ansprüche 1 bis 5, **dadurch gekennzeichnet, dass** der Fluidkanal (30) als ein Versorgungskanal zur Verbindung mit einer Kühlmittelversorgung ausgebildet ist und die zweite hydraulische Schnittstelle (8, 8B) als eine Anschlussschnittstelle zum Anschluss an eine Kühlmittel-Versorgungsleitung als die weitere Fluidleitung (8, 8B) ausgebildet ist, wobei die zweite hydraulische Schnittstelle (8, 8B) an einer gemeinsamen Seite der Basis (18) neben der ersten hydraulische Schnittstelle (8, 8B) angeordnet ist.

8. Anschlusseinrichtung (2) nach dem vorhergehenden Anspruch, **dadurch gekennzeichnet, dass** die beiden Fluidleitungen (8, 8A, 8B) der beiden Leitungen (4, 4A, 4B) jeweils an einer jeweiligen ersten hydraulischen Schnittstelle (8, 8A) angeschlossen sind und jede der ersten hydraulischen Schnittstellen (8, 8A) jeweils mit einer jeweiligen durch die zweite hydraulische Schnittstelle (8, 8B) gebildete Anschlussschnittstelle über einen jeweiligen als Versorgungskanal ausgebildeten Fluidkanal (30) verbunden sind.

9. Anschlusseinrichtung (2) nach einem der vorhergehenden Ansprüche,
**dadurch gekennzeichnet, dass** an der Leitung (4, 4A) an gegenüberliegenden Enden jeweils ein Anschlussterminal (6) angeschlossen ist und die Fluidleitung (8,8A, 8B) ist an zwei Basen (18) über jeweils eine hydraulische Schnittstelle (28, 28A, 28B) angeschlossen ist, wobei über die Leitung (4, 4A) im montierten Zustand zwei elektrische Komponenten (24) miteinander verbunden sind.

10. Anschlusseinrichtung (2) nach dem vorhergehenden Anspruch, bei der zwei Leitungen (4, 4A, 4B) insbesondere parallel zueinander geführt sind und die beiden Leitungen (4, 4A, 4B) jeweils an den beiden Basen (18) angeschlossen sind und die eine Basis (18) den Verbindungskanal (30) gemäß Anspruch 6 aufweist, über den die beiden Fluidleitungen (8,8A, 8B) der beiden elektrischen Leitungen (4, 4A, 4B) miteinander verbunden sind und die andere Basis (18) zwei Versorgungskanäle (30), wobei an jedem der Versorgungskanäle jeweils eine der Fluidleitungen (8,8A, 8B) der beiden Leitungen (4, 4A, 4B) angeschlossen ist und im montierten Zustand jeweils eine Versorgungsleitung.

11. Elektrische Anschlusseinrichtung (2) insbesondere nach einem der vorhergehenden Ansprüche mit einer kühlbaren elektrischen Leitung (4, 4A) und mit einem Anschlussterminal (6), über die die elektrischen Leitung (4, 4A) im montierten Zustand an einer elektrischen Komponente (24) angeschlossen ist, wobei die kühlbare elektrische Leitung (4, 4A) zumindest eine integrierten Fluidleitung (8, 8A, 8B) für ein Kühlmittel, zumindest einen elektrischen Leiter (10) zur Stromübertragung und einen isolierenden Leitungsmantel (16) aufweist, und wobei die elektrische Leitung (4, 4A) mit einem Endabschnitt in das Anschlussterminal (6) eingeführt ist, wobei das Anschlussterminal (6) ein Terminalgehäuse (22) aufweist, welches im montierten Zustand an einer Basis (18) angeschlossen ist, **dadurch gekennzeichnet, dass** die Leitung (4, 4A) als eine geschirmte Leitung (4, 4A) ausgebildet ist und eine Schirmlage (14) aufweist.

12. Anschlusseinrichtung (2) nach dem vorhergehenden Anspruch, **dadurch gekennzeichnet, dass** die Schirmlage (14) endseitig mit einem Schirmgehäuse elektrisch kontaktiert ist, wobei das Terminalgehäuse (22) bevorzugt zugleich das Schirmgehäuse ausbildet.

13. Anschlusseinrichtung (2) nach dem vorhergehenden Anspruch, **dadurch gekennzeichnet, dass** das Schirmgehäuse zumindest eine verschließbare Revisionsöffnung (26) aufweist, wobei diese im geschlossenen Zustand bevorzugt mit Hilfe eines Schirmelements (27) überdeckt ist.

14. Anschlusseinrichtung (2) nach einem der Ansprüche 12 bis 13, **dadurch gekennzeichnet, dass**
- der Leiter (10) innerhalb des Schirmgehäuses über einen Kontaktverbinder (32) elektrisch mit einem Anschlussleiter (20) verbunden ist, welcher durch die Basis (18) geführt ist, und dass das Schirmgehäuse mit der Basis (18) verbunden ist und / oder
- die erste hydraulische Schnittstelle (8, 8A) innerhalb des Schirmgehäuses angeordnet ist und dass der die beiden hydraulischen Schnittstellen (8, 8A, 8B) verbindende Fluidkanal (30) innerhalb der Basis (18) oder auf einer dem Schirmgehäuse abgewandten Seite der Basis (18) verläuft..

15. Anschlusseinrichtung (2) nach einem der vorhergehenden Ansprüche,
**dadurch gekennzeichnet, dass** die Basis (18) Teil einer ersten Gehäusewand (42) der Komponente (24) ist und dass innerhalb einer zweiten Gehäusewand (50) der Komponente (24) eine Kühlstruktur (48) ausgebildet ist, wobei an der zweiten hydraulischen Schnittstelle (8B) eine Verbindungsleitung (52) angeschlossen ist, über welche das Kühlmittel der Kühlstruktur (48) in der zweiten Gehäusewand (50) zuführbar ist.
